(19) Europäisches Patentamt / European Patent Office / Office européen des brevets

(11) **EP 3 235 893 A1**

(12) **EUROPEAN PATENT APPLICATION**
published in accordance with Art. 153(4) EPC

(43) Date of publication:
**25.10.2017 Bulletin 2017/43**

(21) Application number: **15858123.1**

(22) Date of filing: **20.11.2015**

(51) Int Cl.:
***C09K 11/88*** *(2006.01)* ***C09K 11/02*** *(2006.01)*
***G02B 5/20*** *(2006.01)* ***G02B 1/04*** *(2006.01)*
***G02F 1/1335*** *(2006.01)* ***G03F 7/027*** *(2006.01)*

(86) International application number:
**PCT/CN2015/095105**

(87) International publication number:
**WO 2016/095657 (23.06.2016 Gazette 2016/25)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **19.12.2014 CN 201410805740**

(71) Applicant: **BOE Technology Group Co., Ltd.**
**Beijing 100015 (CN)**

(72) Inventors:
- **XIN, Yangyang**
  **Beijing 100176 (CN)**
- **LUN, Jianchao**
  **Beijing 100176 (CN)**
- **LI, Lin**
  **Beijing 100176 (CN)**

(74) Representative: **Cohausz & Florack**
**Patent- & Rechtsanwälte**
**Partnerschaftsgesellschaft mbB**
**Bleichstraße 14**
**40211 Düsseldorf (DE)**

(54) **MODIFIED QUANTUM DOT AND PREPARATION METHOD THEREFOR, COLORANT, PHOTOSENSITIVE RESIN COMPOSITION, COLOR FILTER AND DISPLAY DEVICE**

(57) The invention provides a modified quantum dot, a method for preparing the same, a coloring agent, a photosensitive resin composition, a color filter and a display device. Said modified quantum dot can improve the overall dispersibility and optical properties of the coloring agent, and further increase the contrast ratio of the display device. The modified quantum dot of the present invention has the following structure:

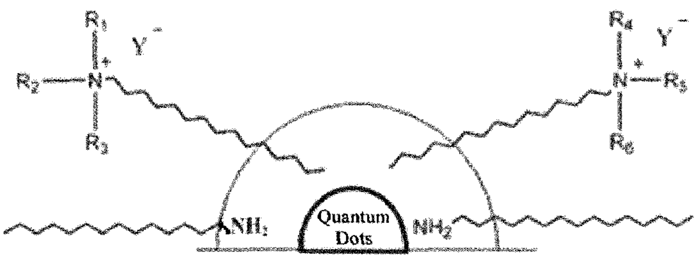


the modified quantum dot comprises a core composed of quantum dots and a shell composed of amines containing a C6-C22 alkyl group, wherein, some or all amino groups in the amine form salts with an acid dye, and $Y^-$ is an anion in the acid dye, $R_1$, $R_2$, $R_3$, $R_4$, $R_5$ and $R_6$ are independently H or a C1-C6 alkyl group.

EP 3 235 893 A1

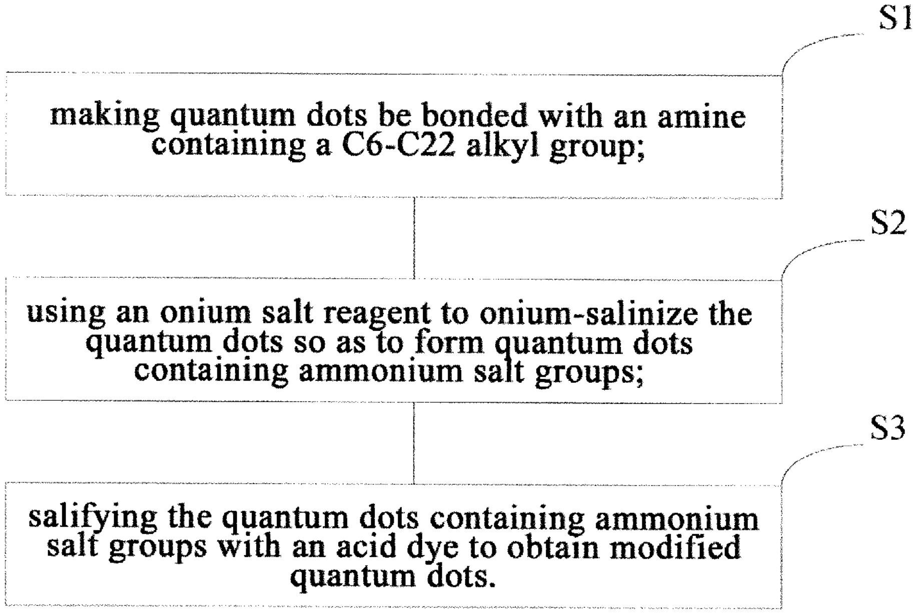
S1
making quantum dots be bonded with an amine containing a C6-C22 alkyl group;
S2
using an onium salt reagent to onium-salinize the quantum dots so as to form quantum dots containing ammonium salt groups;
S3
salifying the quantum dots containing ammonium salt groups with an acid dye to obtain modified quantum dots.

Fig. 1

## Description

### FIELD OF THE INVENTION

The present invention relates to the field of display technology, in particular, to a modified quantum dot and a method for preparing the same, a colorant, a photosensitive resin composition, a color filter and a display device.

### BACKGROUND

Color filters are important components in liquid crystal displays because liquid crystal displays rely on them for displaying color images. Conventional manufacturing processes of color filters mainly include dyeing method, pigment dispersion method, electrode position method, and printing method, wherein the pigment dispersion method is generally used due to its simple process and good weather resistance. Generally, in the pigment dispersion method, patterning can be realized by a series of operations such as coating a photoresist on a substrate, exposing, and developing, such that a color filter is formed.

In the pigment dispersion method, pigments are generally used as a colorant. However, in prior art methods, pigments do not have good dispersion property in photoresists, and further have low color light transmission. Later, dyes are proposed to replace pigments. However, as dyes have poor solvent resistance, when they are used as a colorant in photoresist, they show worse heat resistance and light resistance than pigments.

### SUMMARY

The main object of the present invention is to provide a modified quantum dot having excellent stability, high luminescence and light transmittance and a method for preparing the same, a colorant comprising these modified quantum dots, a photosensitive resin composition, a color filter and a display device.

To achieve the above object, the present invention adopts the following technical solution.

In one respect, the present invention provides a modified quantum dot having a structure shown in the figure below:

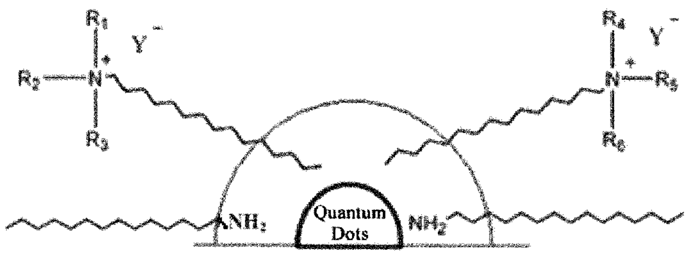

;

the modified quantum dots comprises a core composed of quantum dots and a shell composed of amines containing a C6-C22 alkyl group(s),

wherein, some or all amino groups in the amine form salts with an acid dye,

$Y^-$ is an anion in the acid dye, $R_1$, $R_2$, $R_3$, $R_4$, $R_5$ and $R_6$ are independently H or a C1-C6 alkyl group.

Alternatively, the quantum dot is a quantum dot emitting red light, and the acid dye is a red acid dye. Preferably, the quantum dot emitting red light is CdSe.

Preferably, the amine containing a C6-C22 alkyl group is oil amine.

In another respect, the present invention provides a colorant comprising the modified quantum dots as described above. The colorant is manufactured by mixing the modified quantum dots according to the present invention with pigments.

Preferably, the colorant is manufactured by mixing the modified quantum dots with a pigment dispersion, wherein the pigment dispersion comprises a pigment, a dispersant, a dispersion resin and a solvent.

The weight percents of the pigment, dispersant, dispersion resin and solvent in the pigment dispersion are respectively 5-30%, 1-10%, 1-10% and 60-90% by weight.

Preferably, the quantum dot in the modified quantum dot is a quantum dot emitting red light, the acid dye is a red acid dye, and the pigment is a red pigment. Preferably, the quantum dot emitting red light is CdSe.

In another respect, the present invention provides a photosensitive resin composition comprising the above-mentioned colorant of the present invention. The photosensitive resin composition may be formed by mixing the colorant

according to the present invention, an alkali-soluble resin, a monomer, an initiator, and a solvent.

Preferably, the total content of the colorant, alkali-soluble resin, monomer and initiator accounts for 10-40% by weight based on the photosensitive resin composition, and the solvent accounts for 60-90% by weight based on the photosensitive resin composition.

Preferably, the contents of the colorant, alkali-soluble resin, monomer, and initiator based on the total content thereof are respectively 10-80%, 5-60%, 5-60%, 0.1-20% by weight.

More preferably, the contents of the colorant, alkali-soluble resin, monomer, and initiator based on the total content thereof are respectively 30-60%, 10-30%, 10-30%, 1-10% by weight.

In another respect, the present invention provides a color filter, which is manufactured by the photosensitive resin composition of the present invention.

In another respect, the present invention further provides a display device, comprising a color filter substrate disposed with the color filter of the present invention.

In another respect, the present invention provides a method for preparing the above-mentioned modified quantum dots, include:

making quantum dots be bonded with amine containing a C6-C22 alkyl group;
using an onium salt reagent to onium-salinize the quantum dots so as to form quantum dots containing ammonium salt groups;
salifying the quantum dots containing ammonium salt groups with an acid dye to obtain modified quantum dots.

Preferably, a amine value of the quantum dot containing ammonium salt groups is 10 mgKOH/g to 200 mgKOH/g.

More preferably, the amine value of the quantum dot containing ammonium salt groups is 20 mgKOH/g to 130 mgKOH/g.

The modified quantum dot according to the present invention comprises a core composed of quantum dots and a shell composed of amines containing a C6-C22 alkyl group(s). On one hand, the C6-C22 alkyl groups increase the dispersibility of the quantum dots in an organic solvent, stabilize the core-casing structure to prevent quantum dots accumulation, and increase the quantum yield of the quantum dots. On the other hand, the amino groups may react with the acid dyes to form salts, therefore the quantum dots and the dye are bonded together to further improve the dispersibility of the quantum dots, which is good for increasing color quality such as a contrast ratio and the like properties. Further, the acid dyes react with the quantum dots comprising amino groups to form salts, so that the dye originally having low thermal stability and light stability obtains better stability by forming a larger molecule through the reaction. And thus, a decomposition of the dye can be avoided. In addition, by means of a strong light transmittance of the acid dyes and a light-emitting property of the quantum dots, when the acid dyes combined with quantum dots are mixed with pigments to serve as a colorant, it improves the poor light transmittance of the pigments, and enhances the overall dispersibility and optical characteristics of the colorant, thereby increases the contrast ratio and the like properties of display devices.

## BRIEF DESCRIPTION OF THE DRAWINGS

Figure 1 shows a flow chart of the method for preparing the modified quantum dots according to an embodiment of the present invention.

Figure 2 shows an UV-visible absorption spectrum of the modified CdSe quantum dots according to an embodiment of the present invention.

Figure 3 shows a photoluminescence spectrum of the modified CdSe quantum dots according to an embodiment of the present invention

## DESCRIPTION OF EMBODIMENTS

Hereafter, embodiments of the present invention will be described in detail with reference to the accompanying figures. It should be understood that, the embodiments described here is used for illustrating the present invention only, and not intended to limit the present invention.

The present invention provides a modified quantum dot having a structure shown in the figure below:

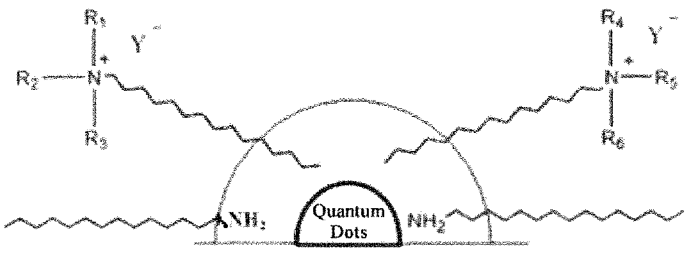

;

the modified quantum dot comprises a core composed of quantum dots and a shell composed of amines containing a C6-C22 alkyl group(s),

wherein, some or all amino groups in the amine form salts with an acid dye,

$Y^-$ is an anion in the acid dye, $R_1$, $R_2$, $R_3$, $R_4$, $R_5$ and $R_6$ are independently H or a C1-C6 alkyl group.

The C2-C22 alkyl group is preferably a straight or branched aliphatic alkyl group. $R_1$ to $R_6$ may all be H, or a C1-C6 alkyl group. The C1-C6 alkyl group may be a substituted or unsubstituted alkyl group, a substituted or unsubstituted alkenyl group, wherein the substituent may be alkyl or halogen. The C1-C6 alkyl group may be a straight or branched alkyl or alkenyl group, such as methyl, vinyl, isopropyl, allyl, butyl and the like.

For simplicity, the above figure only shows a cross section view of the upper half structure of the quantum dot, wherein the central semi-circle represents the core composed of the quantum dots, and the outer semi-circle represents the shell composed of amines containing a C6-C22 alkyl group. It can be seen that the amines containing a C6-C22 alkyl group wrap the core composed of the quantum dots. Although the figure only shows four amines containing a C6-C22 alkyl group, it should be understood the number of the amines in each of the modified quantum dot is not limited so.

The amines containing a C6-C22 alkyl group attach to the surface of the quantum dots via a non-covalent bond, which should be understood as van der Waals force.

To make the amino groups react with the acid dyes to form salts, an onium salt reagent can be used preferably to convert the amino groups to ammonium ions, and further the ammonium ions react with the acid dyes to form salts. Thus, the modified quantum dot in embodiments of the present invention can be described as a salt or a composite formed by the quantum dots bonded with amines and the acid dye.

A modified quantum dot according to an embodiment of the present invention comprises a core composed of quantum dots and a shell composed of amines containing a C6-C22 alkyl group(s). On one hand, the C6-C22 alkyl group increases the dispersibility of the quantum dots in an organic solvent; stabilize the core-casing structure to prevent quantum dots accumulation; and increase the quantum yield of the quantum dots. On the other hand, the amino groups may react with the acid dyes to form salts, therefore the quantum dots and the dye are bonded together to further improve the dispersibility of the quantum dots, which is good for increasing color quality such as a contrast ratio and the like properties. Further, the acid dyes react with the quantum dots comprising amino groups to form salts, so that the dye originally having low thermal stability and light stability obtains better stability by forming a larger molecule through the reaction. And thus, a decomposition of the dye can be avoided. In addition, by means of a strong light transmittance of the acid dyes and a light-emitting property of the quantum dots, when the acid dyes combined with quantum dots are mixed with pigments to serve as a colorant, it improves the poor light transmittance of the pigments, and enhances the overall dispersibility and optical characteristics of the colorant, thereby increases the contrast ratio and the like properties of display devices.

Preferably, in the embodiment of the present invention, the quantum dots may be a quantum dot emitting red light, and the acid dye may be a red acid dye.

For example, the quantum dot emitting red light may be any one selected from CdS, CdSe, CdTe; preferably CdSe since it has good optical properties and stability.

For example, the red acid dye may be azos, anthraquinones, triarylmethanes, xanthenes, phthalocyanines and the like. Xanthene dyes may be, for example, C.I. Acid Red 52, C.I. Acid Red 87, C.I. Acid Red 92, C.I. Acid Red 289 and so on. Xanthene dyes contain sulfonic acid groups, and thus contribute to the acid dyes reacting with the amino groups to form salts. The present invention is not limited in these acid dyes, and any other acid dyes applicable can be used in the present invention.

Of course, the quantum dots may be a quantum dot emitting green light, the acid dye may be a green acid dye. Alternatively, the quantum dots may be a quantum dot emitting blue light, the acid dye may be a blue acid dye. In other words, embodiments of the present invention is not limited to the quantum dot emitting red light which forms a salt only with red pigments, other modified quantum dots that form salts with pigments having corresponding colors are applicable as well, they can also increase the dispersibility of the quantum dots, and improve stability of the pigments.

In one embodiment of the present invention, the amine containing a C6-C22 alkyl group may be hexadecylamine, dodecylamine or octadecylamine, such as oil amine and the like. The amine containing a C6-C22 alkyl group provides

C6-C22 alkyl group to wrap the core composed of quantum dots, and also improves the particle stability of the quantum dots.

Preferably, the amine containing a C6-C22 alkyl group is oil amine, which includes an olefinic bond contributing to directional growth of the quantum dots, and further to adjusting the size of the quantum dots, such that the quantum dots will have better spectral properties.

According to another embodiment of the present invention, there provides a colorant comprising the modified quantum dots as described above, in which the shell comprises a salt formed by an amine and an acid dye. The colorant is manufactured by mixing the modified quantum dots with pigments. The modified quantum dots have characteristics such as high dispersibility and high quantum yield, and can improve a contrast ratio of a display device, and improve a stability of the acid dye. More importantly, by means of a strong light transmittance of the acid dyes and a light-emitting property of the quantum dots, when the acid dyes combined with quantum dots are mixed with pigments to serve as a colorant, it improves the poor light transmittance of the pigments, and enhances the overall dispersibility and optical characteristics of the colorant, thereby increases the contrast ratio and the like properties of display devices.

The color of the pigments should match the color of the light emitted from the quantum dots and the color of the acid dyes. For example, when the quantum dots and acid dyes are red, a red pigment should be used. The same principle applies to the case of blue or green.

Available pigment species include diketopyrrolopyrrole pigment, and/or anthraquinone pigment, and/or monoazo or disazo pigment.

For example, specifically, a red diketopyrrolopyrrole pigment may be C.I. Pigment Red 254, 255, and the like; a red anthraquinone pigment may be C.I. Pigment Red 177; a red monoazo or disazo pigment may be Pigment Red C.I. 166, 220, 242 and C.I. pigment orange 38. In addition, in order to acquire a good color harmony, a yellow pigment such as C.I. Pigment Yellow 150 and the like maybe mixed with a red pigment properly.

In embodiments of the present invention, a ratio of the pigments in the colorant to the modified quantum dots (salt product) may be 100:1-1:100, preferably, 100:40-40:100. Particular, the ratio may be, for example, 100: 45, 100:50, 100:60, 100:70, 100:80, 100:90, 100:100, 90:100, 80:100, 70:100, 60:100, 50:100, and 40:100. A colorant prepared according to these ratios has better coloring characteristics.

Alternatively, the pigment may be in a form of a pigment dispersion. Optionally, the percentage of the pigment in the pigment dispersion is 5-30% by weight, preferably 10-20% by weight.

The pigment dispersion may include a dispersant. The dispersant is used for dispersing the pigment, and it helps to improve the pigment dispersibility. The dispersant may be commercially available pigment wetting and dispersing agents like BYK, Solsperse, EFKA, Ajinomoto and so on. The present invention does not put a limit on it.

Available dispersant may be a resin dispersant, e.g., EFKA4300. The content of the dispersant in the pigment dispersion may be 1%-10% by weight, e.g., 1%, 2%, 3%, 4%, 5%, 6%, 7%, 8%, 9%, and 10%. The dispersant in this content is advantageous to uniformly dispersing the pigment, and can also ensure the pigment is enough to maintain their properties.

Apart from the above-mentioned dispersant, the pigment dispersion may also include a dispersion resin and/or a solvent.

Available dispersion resin may be acrylic resin, e.g. ACA Z251. A content of the dispersion resin in the pigment dispersion may be 1%-10% by weight, e.g., 1%, 2%, 3%, 4%, 5%, 6%, 7%, 8%, 9%, and 10%. The dispersion resin in this content is advantageous to uniformly dispersing the pigment, and can also ensure the pigment is enough to maintain their properties.

Generally, a content of the solvent in the pigment dispersion is 60-90% by weight, preferably 70-80%; for example, 60%, 65%, 70%, 75%, 80% and so on. The solvent may be alcohols such as isopropanol or ethanol, etc.; esters such as ethyl 3-ethoxypropionate, propylene glycol methyl ether acetate, etc.; ketones such as cyclohexanone; ethers such as propylene glycol methyl ether, diethylene glycol diethyl ether. These solvents may be used alone or as a mixture of two or more.

The quantum dot in the modified quantum dots may be a quantum dot emitting red light, a quantum dot emitting blue light, or a quantum dot emitting green light. Preferably, the quantum dot in the modified quantum dots is a quantum dot emitting red light, the acid dye is a red acid dye, and the pigment is a red pigment. Further, the quantum dot emitting red light is CdSe. This will be helpful to make the red colorant has a better red color strength, and achieve a higher red color purity.

Another embodiment of the present invention provides a photosensitive resin composition comprising the above-mentioned colorant of the present invention. The photosensitive resin composition may be formed by mixing the colorant, an alkali-soluble resin, a monomer, an initiator, and a solvent.

The alkali-soluble resin may be selected from (meth)acrylic resins, preferably, a copolymer made by polymerizing (meth)acrylic acid with (meth)acrylate or other compound containing double bond. Specifically, resin products under trade name V259ME and V301ME manufactured by Nippon Steel Chemical.

The monomer may be a polymerizable monomer, preferably acrylate monomer like pentaerythritol triacrylate,

dipentaerythritol triacrylate, pentaerythritol tetraacrylatem, dipentaerythritol tetraacrylate, dipentaerythritol pentaacrylate, dipentaerythritol hexaacrylate.

The initiator may be a photopolymerization initiator, preferably any one of diimidazole compound, benzoin-based compound, polynuclear quinone compound, benzoin-based compound, benzophenone-based compound, acetophenone-based compound, triazine compound, diazo compound, xanthone-based compound, oxime ester compound, iodonium salt, sulfonium salt and the like, or any combination thereof.

The solvent may be any solvent which is capable of dispersing or dissolving the above-mentioned components or other additives in the photosensitive resin composition, do not react with these components, and have suitable volatility. Such solvents include propylene glycol methyl ether acetate, cyclohexanone, propylene glycol methyl ether, diethylene glycol diethyl ether, 3-ethoxypropionate, etc. These solvents may be used alone or as a mixture of two or more.

According to the present invention, except to the above-mentioned colorant, alkali-soluble resin, monomer, initiator and solvent, the photosensitive resin composition used for a color filter also comprises other additives if necessary, for example, surfactants like non-ionic surfactants, cationic surfactants, anionic surfactants etc., vinyl trimethoxysilane, 3-mercaptopropyl trimethoxy silane adhesion promoter; and antioxidants like 2,6-di-t-butylphenol and other.

In a preferred embodiment of the present invention, the specific contents of each component in the photosensitive resin composition are described as follows.

The colorant, alkali-soluble resin, monomer and initiator are together referred to as active ingredients, that is, the photosensitive resin composition is composed of active ingredients and a solvent. Optionally, the active ingredients account for 10-40% by weight based on the photosensitive resin composition, e.g. 10%, 20%, 30%, 40%; the solvent accounts for 60-90% by weight based on the photosensitive resin composition, e.g., 60%, 70%, 80%, 90%. In the actual mixing process, some of the active ingredients (e.g., pigments in the colorant) may be preferably dissolved in the solvent before being mixed with other ingredients. In this case, the content of the active ingredient is calculated in their own weight.

More preferably, the contents of the colorant, alkali-soluble resin, monomer, and initiator are respectively 10-80%, 5-60%, 5-60%, 0.1-20% by weight based on the total weight thereof. More preferably, these contents are respectively 30-60%, 10-30%, 10-30%, 1-10% by weight based on the total weight thereof. For example, the content of the colorant may be 10%, 20%, 30%, 40%, 50%, 60%, 70%, 80% by weight based on the total weight thereof; the content of the alkali-soluble resin may be 5%, 10%, 20%, 30%, 40%, 50%, 60% by weight based on the total weight thereof; the content of the monomer may be 5%, 10%, 20%, 30%, 40%, 50%, 60% by weight based on the total weight thereof; the content of the initiator may be 0.1%, 1%, 5%, 10%, 15%, 20% by weight based on the total weight thereof.

The proportions provided in the preferred embodiments of the present invention can lead to synergistic effect among the components, and is advantageous to imparting properties like a high brightness or a contrast ratio to the color filter coated with the above-mentioned photosensitive resin composition.

Another embodiment of the present invention provides a color filter, which is manufactured by the photosensitive resin composition provided by the present invention. The color filter can be manufactured with prior art techniques. The present invention dose not put a limit on this.

The color filter of the present embodiment is formed by subjecting the above-described photosensitive resin composition to coating, exposing, developing, and baking treatment. Since the colorant in the photosensitive resin composition has high quantum yield, improved stability and light transmittance, therefore, the formed color filter has excellent heat resistance and light resistance, and high light transmittance.

Another embodiment of the present invention further provides a display device, comprising a color filter substrate disposed with the color filter of the present invention. The display device has advantages like a high contrast ratio, a long operating life and others due to the color filter with excellent heat resistance and light resistance.

Another embodiment of the present invention provides a method for preparing modified quantum dots, include:

S1, making quantum dots be bonded with amines containing a C6-C22 alkyl group, such that the obtained quantum dots comprises a core composed of quantum dots and a shell composed of amines containing a C6-C22 alkyl group;
S2, using an onium salt reagent to onium-salinize the quantum dots so as to form quantum dots containing ammonium salt groups;
S3, salifying the quantum dots containing ammonium salt groups with an acid dye to obtain modified quantum dots.

Figure 1 shows a flow chart of the method for preparing the modified quantum dots according to embodiments of the present invention. In step S1, there is a variety of ways to make the quantum dot be bonded with a hydrocarbon containing amino groups. For example, a lot of precursors are used during the preparation of quantum dots, and even after synthesis of these quantum dots, some precursors still wrap the quantum dots. These precursors may be amines containing a C6-C22 alkyl group, which forms the core-shell structure described above with said quantum dots. Of course, the present invention does not put a limit on this as there are other means to bond amine containing C6-C22 alkyl group to the quantum dot. The following structure shows a quantum dot bonded with amine containing a C6-C22 alkyl group.

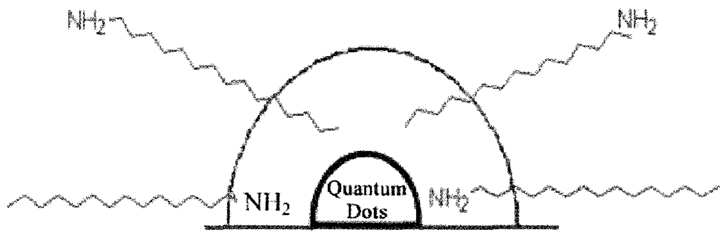

In step S2, after synthesis of the quantum dot containing ammonium salt groups, an onium salt reagent is added to form a quantum dot containing ammonium ion. The onium salt reagent may be alkyl sulfate, e.g., dimethyl sulfate, diethyl sulfate, dipropyl sulfate; or alkyl sulfonate, e.g., p-toluate, methyl benzenesulfonate; or alkyl chloride, e.g., methyl chloride, ethyl chloride; or alkoxycarbonyl alkyl halide, e.g., alkoxycarbonyl alkyl chloride, alkoxycarbonyl alkyl bromide and the like.

When taking alkoxycarbonyl alkyl chloride as the onium salt reagent, the following structure shows the quantum dot containing ammonium ion obtained by treating the quantum dot containing ammonium salt groups with this onium salt reagent.

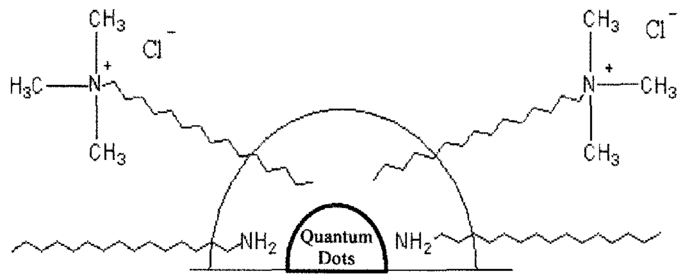

During onium salinization, the molar ratio of onium salt reagent to amino group is 1:1, which is realized by adding to a solution of quantum dot with onium salt reagent in the same molar amount as amino group in the quantum dot.

During onium salinization, the reaction temperature is preferably controlled at 25-35°C, more preferably at 30°C. The reaction time is preferably 1-4 hours.

The amine value of the quantum dot containing ammonium ion may be 10 to 200 mgKOH/g, for example, 10-190 mgKOH/g, 15-180 mgKOH/g, 20-180 mgKOH/g, 20-160 mgKOH/g, more preferably, 20-130 mgKOH/g, specifically, 20mgKOH/g, 60mgKOH/g, 80mgKOH/g, 100 mgKOH/g, 130 mgKOH/g and so on. When the amine value is within these ranges, the core of the quantum dot is wrapped with a considerable amount of ammonium ion, which may cooperate with anionic groups in the acid dyes in a proper amount, so as to further enhance the dispersibility of the quantum dot in an organic solvent.

In step S3, the quantum dot containing ammonium ion may be dissolved first before mixing it with the acid dyes. The ammonium ion in the quantum dot forms a salt product with the anionic groups in the acid dyes through ion bonding.

Usually, the quantum dot containing ammonium ion is dissolved in a mixed solution of water and a water-soluble organic solvent. Preferably, in the mixed solution, the weight percent of the water-soluble organic solvent in the total weight of the mixed solution is 5 to 50%, more preferably, 5-20%, e.g. 8%, 10%, 11%, 15%, 20%.

wherein the water-soluble organic solvent may be selected from methanol, ethanol, n-propanol, isopropanol, 1-methoxy-2-propanol, 1-ethoxy-2-propanol, n-butanol, isobutanol, 2-(methoxymethoxy) ethanol, 2-butoxyethanol, 2-(isopentyloxy) ethanol, 2-(hexyloxy) ethanol, ethylene glycol, ethylene glycol monomethyl ether, ethylene glycol monobutyl ether, diethylene glycol, diethylene glycol monomethyl ether, diethylene glycol monoethyl ether, diethylene glycol monobutyl ether, propylene glycol, propylene glycol monomethyl ether acetate, dipropylene glycol, dipropylene glycol monomethyl ether, dipropylene glycol monoethyl ether, triethylene glycol, triethylene glycol monomethyl ether, polyethylene glycol, glycerol, tetraethylene glycol, diethylene glycol, acetone, diacetone alcohol, aniline, pyridine, ethyl acetate, isopropyl acetate, methyl ethyl ketone, n, n- dimethyl formamide, dimethyl sulfoxide, tetrahydrofuran (thf), dioxane, 2-pyrrolidone, 2-methylpyrrolidone, n- methyl-2-pyrrolidone, 1,2-hexanediol, 2, 4, 6-hexanetriol, tetrahydrofurfuryl alcohol, 4-methoxy-4-methyl-pentanone etc.

In the mixed solution, the ammonium ion in the quantum dot forms a salt product with the anionic groups in the acid dyes through ion bonding, separating the resultant product to obtain a modified quantum dot.

The method of the present invention yields a quantum dot containing ammonium ion by bonding an amine containing C6-C22 alkyl group to the core of the quantum dot, and onium-salinizing the amine. Further, the quantum

dot containing ammonium ion is mixed with acid dyes in a water-soluble organic solvent to obtain a modified quantum dot. The modified quantum dot has fine dispersibility, high quantum yield, and good stability.

The present invention will be described in detail below with specific embodiments. In the following embodiments, all the reagents are purchased from Dow Chemical unless indicated otherwise. In addition, pbw means part by weight in the whole Specification.

**Examples of synthesis of a modified quantum dot**

**Example a**

First, a quantum dot containing amino groups is prepared by following steps:

(1) Weighing 0.177g CdO, 1g oleic acid, 2g octadecene, putting them into a clean, dry three-necked flask, and adding magneton in appropriate size.

(2) Filling the three-necked flask equipped with a magnetic stirrer with nitrogen, stirring while heating to 280°C(at 250°C the raw materials begin to dissolve) until the raw material melt turns to colorless and transparent.

(3) Cooling to under 50°C, adding 8g octadecene, and changing the nitrogen gas vent to a condenser tube at the middle neck of the flask.

(4) Continue to heating until the temperature reaches 280°C, using a syringe to draw a premixed solution of 0.2607g Se, 3g of trioctylphosphine (TOP) and 0.5g oil amine. Prior to drawing said premixed solution, draw nitrogen twice to clear air out of the syringe. If desired, Se may be properly heated to melt until turns colorless and transparent, and quickly injected into the three-necked flask. And then extracting the solution after 10 minutes' reaction.

In addition to the above-mentioned method for preparing quantum dots containing amino groups, the following method may also be used:

(1) Weighing 1.284g (10 mmol) CdO powder in a conical flask, adding 7.6 mL oleic acid and 17.4 mL liquid paraffin, slowly heating to 150°C until a dark red transparent precursor liquid is formed.

(2) Weighing 0.079g (1.0 mmol) Se powder in a four-necked flask, add 43mL liquid paraffin, slowly heating to 220°C until a clear bright yellow precursor liquid is formed.

(3) Extracting 5mL Cd precursor solution and rapidly injecting it into Se precursor solution, adding 2mL oil amine, and rapidly stirring to make the solution rapidly change to orange.

(4) Keeping the temperature at 220°C to make the quantum dots gradually grow. Taking out 2mL quantum dot solution at different times and it add to 3mL cold toluene to stop the growth of quantum dots.

After synthesis of a quantum dot containing amino groups with any one of the above-mentioned methods, reacting the quantum dot containing amino groups with an onium salt reagent to form a quantum dot containing ammonium ion, specific steps are as follows.

CdSe quantum dot containing amino groups undergoes onium reaction with methyl chloride to generate CdSe quantum dot containing ammonium ion, the structure thereof is shown below. The reaction temperature is controlled at about 30°C, the reaction time is 1-4 hours.

The resultant quantum dot containing ammonium ion has a amine value of 34mg KOH/g, which is calculated by titrating the resultant quantum dot with a 0.1 mol/L aqueous solution of silver nitrate to obtain the amount of silver nitrate required to neutralize the ammonium salt, and converting it to the equivalent value of KOH, with an indicator being a 5% by weight aqueous solution of potassium chromate.

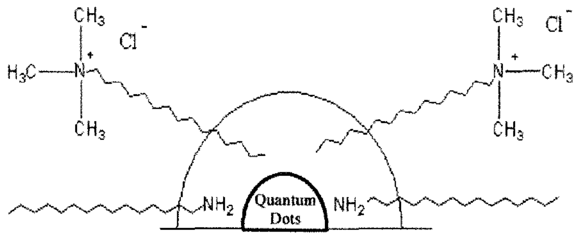

Finally, a modified quantum dot is obtained by reacting the quantum dot containing ammonium ion and an acid dye:

Adding 65 pbw (part by weight) of the quantum dot containing ammonium ion CdSe to 2000 pbw acetic acid solution (acetic acid content: 20% by weight), and heating to 60°C after sufficient stirring; and then adding dropwise the pre-conditioned aqueous of C.I. Acid Red 52 (10pbw C.I. Acid Red 52 in 90pbw water) in small amount at multiple times into the quantum dot solution. After adding being completed, stirring the mixture at 60°C for 120 minutes for full reaction. Then dropping the reactant solution on a filter paper, and reaction being completed until no permeation occurs, so as to obtain the modified quantum dot. Stirring the mixture, cooling it to room temperature, filtrating and washing it with water. Drying the remaining modified quantum dots on filter paper with a dryer to move the water to further get the modified quantum dots.

The following shows an ultraviolet-visible absorption spectrum test of the modified quantum dots to verify the red light spectrum of the modified quantum dots.

Extracting a small amount of the solution of modified quantum dots with a syringe, and dispersing the same in n-hexane. Using an absorption spectrometer to test the solution's absorption spectrum as follows:

(1) First, preheating the spectrometer for 20 min, and running a pre-test with the test software.

(2) Adding n-hexane to two cuvettes respectively, putting the cuvettes into the spectrometer for limitation testing. Test spectrum is set to 380nm-780nm, and starting the test.

(3) After then, replacing one cuvette having n-hexane with a cuvette having modified quantum dots, starting to test and save the result.

Figure 2 shows absorption spectrum graph of the modified quantum dots. It clearly indicates a relatively strong absorption in ultraviolet band, and substantially no absorption in infrared band, suggesting the modified quantum dots emit red light.

Further, the photoluminescence test verifies again the modified quantum dots emit red light as follows:

(1) Preferably in a darkroom condition, adding the modified quantum dots having a concentration of about 0.01mg/ml into a cuvette, and putting the cuvette into the apparatus;

(2) Setting the test spectrum at 380nm-780nm in the software, running the test and then save the result.

Figure 3 shows photoluminescence spectrum graph of the modified quantum dots. It clearly illustrates the photoluminescence spectrum reaches a peak at around 570nm, and the emission peak has a small width, indicating the quantum dots is emit red light and has a good photoluminescence performance.

Example b

The specific synthetic method and steps are the same as Example a, except that oil amine is replaced by dodecylamine.

Example c

The specific synthetic method and steps are the same as Example a, except that C.I. Acid Red 52 is replaced by C.I. Acid Red 92.

**Examples of preparation of color filter**

1) Preparation of pigment dispersion

Preparing pigment dispersions PM-1 to PM-6 by the following method based on the components and the amounts thereof shown in Table 1.

Evenly mixing the pigment, dispersant, dispersion resin and solvent listed in Table 1, dispersing the mixture in a mill (Wahl Po DYNO-MILL RESEARCH LAB) with zirconium oxide beads having a diameter of 0.5mm for 5 hours, and then filtrating the mixture by a filter of 5.0μm to prepare the pigment dispersion.

**Table 1.** Components and the amounts thereof in pigment dispersions

| Pigment Dispersion | Pigment (powder) | Dispersion Resin (acrylic resin) | Dispersant (resin type) | Solvent |
|---|---|---|---|---|
| PM-1 | C.I. Pigment Red 254<br>15 pbw | ACA Z251<br>5 pbw | EFKA4300<br>3 pbw | propylene glycol methyl ether acetate<br>77 pbw |
| PM-2 | C.I. Pigment Red 177<br>15 pbw | ACA Z251<br>5 pbw | EFKA4300<br>3 pbw | propylene glycol methyl ether acetate<br>77 pbw |
| PM-3 | C.I. Pigment Yellow 150<br>15 pbw | ACA Z251<br>5 pbw | EFKA4300<br>3 pbw | propylene glycol methyl ether acetate<br>77 pbw |
| PM-4 | C.I. Pigment Red 255<br>8 pbw | ACA Z251<br>1 pbw | EFKA4300<br>1 pbw | EFKA4300<br>90 pbw |
| PM-5 | C.I. Pigment Red 166<br>5 pbw | ACA Z251<br>10 pbw | EFKA4300<br>10 pbw | EFKA4300<br>75 pbw |
| PM-6 | C.I. Pigment Red 220<br>30 pbw | ACA Z251<br>5 pbw | EFKA4300<br>5 pbw | EFKA4300<br>60 pbw |

2) Preparation of photosensitive resin composition

The photosensitive resin compositions of Examples 1-6 are prepared with the modified quantum dots prepared in Examples a, b, c and the above-obtained pigment dispersions.

Examples 1-6

Mixing the colorant, alkali-soluble resin, polymerizable monomer, photopolymerization initiator with the solvent shown in Table 2 to obtain a photosensitive resin composition, wherein the alkali-soluble resin B1 is a mixture of V259ME and V301ME (trade names, Nippon Steel Chemical Co.) mixed at a weight ratio of 52.9: 47.1, the polymerizable monomer is purchased from Taiwan Eternal Chemical, the photopolymerization is purchased from BASF, the solvent is from Dow Chemical.

**Table 2.** Components and the amounts thereof in photosensitive resin compositions

| | Alkali-soluble Resin | Polymerizable Monomer | Photopolymerization initiator | Colorant | | | Solvent |
|---|---|---|---|---|---|---|---|
| | | | | Modified quantum dots | Pigment Dispersion | | |
| Ex. 1 | alkali-soluble resin B1 | dipentaerythritol pentaacrylate | OXE01 | a | PM-1 | PM-3 | propylene glycol methyl ether acetate |
| | 30 pbw | 30 pbw | 5 pbw | 20 pbw | 20 pbw | 3 pbw | 1000 pbw |
| Ex. 2 | alkali-soluble resin B1 | dipentaerythritol pentaacrylate | OXE01 | b | PM-1 | PM-3 | propylene glycol methyl ether acetate |
| | 30 pbw | 30 pbw | 5 pbw | 20 pbw | 20 pbw | 3 pbw | 1000 pbw |
| Ex. 3 | alkali-soluble resin B1 | dipentaerythritol pentaacrylate | OXE01 | c | PM-1 | PM-3 | propylene glycol methyl ether acetate |
| | 30 pbw | 30 pbw | 5 pbw | 20 pbw | 20 pbw | 3 pbw | 1000 pbw |
| Ex. 4 | alkali-soluble resin B1 | dipentaerythritol triacrylate | OXE01 | a | PM-4 | | propylene glycol monomethyl ether |
| | 10 pbw | 60 pbw | 20 pbw | 5 pbw | 5 pbw | | 900 pbw |
| Ex. 5 | alkali-soluble resin B1 | dipentaerythritol tetraacrylate | OXE01 | b | PM-4 | | diethylene glycol diethyl ether |
| | 14.9 pbw | 5 pbw | 0.1 pbw | 30 pbw | 40 pbw | | 900 pbw |
| Ex. 6 | alkali-soluble resin B1 | dipentaerythritol hexaacrylate | OXE01 | c | PM-4 | | ethyl 3-ethoxypropionate |
| | 60 pbw | 5 pbw | 0.1 pbw | 20 pbw | 14.9 pbw | | 900 pbw |

Comparative Examples 1-2

Mixing the colorant, alkali-soluble resin, polymerizable monomer, photopolymerization initiator shown in Table 3 with the solvent to obtain a photosensitive resin composition, wherein the alkali-soluble resin B1 is a mixture of V259ME and V301ME (trade names, Nippon Steel Chemical Co.) mixed at a weight ratio of 52.9: 47.1, the polymerizable monomer is purchased from Taiwan Eternal Chemical, the photopolymerization is purchased from BASF, the solvent is from Dow Chemical.

**Table 3.** Components and the amounts thereof in photosensitive resin compositions

| | Alkali-soluble Resin | Polymerizable Monomer | Photopolymerization initiator | Colorant | Solvent |
|---|---|---|---|---|---|
| Com. Ex.1 | alkali-soluble resin B1 | dipentaerythritol pentaacrylate | OXE01 | C.I. Pigment Red 254 | propylene glycol methyl ether acetate |
| | 30 pbw | 30 pbw | 5 pbw | 35 pbw | 1000 pbw |
| Com. Ex.2 | alkali-soluble resin B1 | dipentaerythritol pentaacrylate | OXE01 | C.I. Acid Red 52 | propylene glycol methyl ether acetate |
| | 30 pbw | 30 pbw | 5 pbw | 35 pbw | 900 pbw |

3) Preparation of filter

Coating the photosensitive resin compositions prepared in above Examples and Comparative Examples on a 10cm×10cm glass substrate to obtain a coating film of about 3 μm thick. Pre-baking the film at 90°C for 100s, and irradiating it by an exposure machine (Canon PLA-501F) with UV light at 50 mj/cm$^2$. And developing the film by immersing it in a 0.042% by weight aqueous solution of KOH at 23°C for 2 min, then washing it with deionized water and baking at 230°C for 30 min. Thus a photosensitive resin layer is formed on the glass substrate, i.e., a color filter is formed.

The quality of the color filter is evaluated mainly by its sensitivity, resolution, light transmittance, and heat resistance thereof. The test process and evaluation criteria of these items are shown below, the results are recorded in Table 4.

1) Sensitivity

Irradiating a pattern film having a minimum precision of 3μm with ultraviolet light having 365nm wavelength and 10 mW/cm$^2$ intensity, developing the film in a 0.042 wt% by weight aqueous solution of KOH at 23°C for 40s, then washing the film with pure water for 1 min.

2) Resolution

Measuring a minimum size of the pattern film formed in above sensitivity test.

3) Light transmittance

Measuring a light transmittance of the pattern film at 400 nm by a spectrophotometer.

4) Heat resistance of coating film

Coating an etchant resist material onto a transparent substrate to impart the dry coating film with a thickness of about 2.5 μm, exposing the film to ultraviolet through a mask having a predetermined pattern, developing the film and removing the uncured portions to form a desired pattern. Then, heating the film in an oven at 230°C for 20 min, cooling it and measuring its chrominance 1(L*(1), a*(1), b*(1)) by a microstructure color tester (LCF-100M, Otsuka Electronics Co., Ltd.). Further, for heat resistance test, heating the film in an oven at 250°C for 1 hour, and then measuring its chrominance 2(L*(2), a*(2), b*(2)) in light source C.

Following formula is used to calculate a chromatic aberration ΔEab* based on the measured chrominance, and heat resistance of the coating film is judged by the evaluation criteria below.

$$\Delta Eab^* = \sqrt{((L^*(2)-L^*(1))2+(a^*(2)-a^*(1))2+(b^*(2)-b^*(1))2)}$$

◎: ΔEab * Less than 1.5
○: ΔEab * more than 1.5, and less than 2.5
△: ΔEab * more than 2.5, and less than 5.0
×: ΔEab * more than 5.0

5) Light resistance of coating film

Preparing a substrate by the same method used in heat resistance test above, measuring a chrominance 1(L*(1), a*(1), b*(1)) of the film by a microstructure color tester (CFT-02). Placing the substrate in natural light for 500 hours, taking out the substrate and measuring its chrominance 2(L*(2), a*(2), b*(2)) in light source C. Calculating ΔEab* according to above formula and judging light resistance of the coating film according to the same evaluation criteria described in heat resistance test above.

**Table 4.** Evaluation results of the color filters in Examples 1-6 and Comparative Examples 1-2

| | Sensitivity (mj/cm$^2$) | Resolution (μm) | Light transmittance (%) | Heat resistance | Light resistance |
|---|---|---|---|---|---|
| Ex.1 | 150 | 3 | 35 | ◎ | ◎ |
| Ex.2 | 150 | 3 | 35 | ◎ | ◎ |

(continued)

| | Sensitivity (mj/cm2) | Resolution (μm) | Light transmittance (%) | Heat resistance | Light resistance |
|---|---|---|---|---|---|
| Ex.3 | 150 | 3 | 35 | ◎ | ◎ |
| Ex.4 | 145 | 3 | 34 | ◎ | ◎ |
| Ex.5 | 154 | 3 | 35 | ◎ | ◎ |
| Ex.6 | 145 | 3 | 36 | ◎ | ◎ |
| Com. Ex.1 | 150 | 3 | 20 | ◎ | ◎ |
| Com. Ex.2 | 120 | 20 | 40 | × | × |

Table 4 shows, compared to the filters in Comparative Examples 1-2, the filters prepared by the photosensitive resin compositions according to the present invention have superior sensitivity, resolution, light transmittance, heat resistance, and light resistance after developing, illustrating the filters in the Examples of the present invention have good stability, high luminescence, and excellent light transmittance.

It should be understood that the above embodiments of the invention have been disclosed only for illustrating the principle of the present invention, but they are not intended to limit the present invention. The person skilled in the art can make various modifications and variations of the invention without departing from the spirit and scope of the invention, these modifications and variations of the invention are also included within the scope of the present invention. The protection scope of the present invention is the protection scope of the claims.

## Claims

1. A modified quantum dot, **characterized by** having a structure shown below:

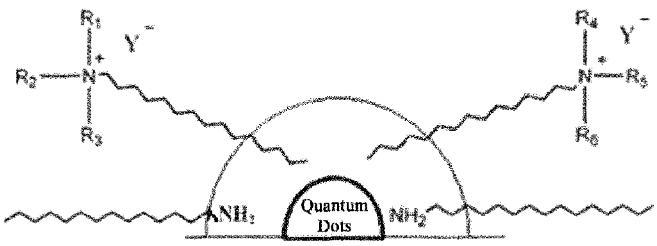

the modified quantum dot comprises a core composed of quantum dots and a shell composed of amines containing a C6-C22 alkyl group,
wherein, some or all amino groups in the amines form salts with an acid dye,
$Y^-$ is an anion in the acid dye, $R_1$, $R_2$, $R_3$, $R_4$, $R_5$ and $R_6$ are independently H or a C1-C6 alkyl group.

2. The modified quantum dot according to claim 1, wherein the quantum dot is a quantum dot emitting red light, the acid dye is a red acid dye.

3. The modified quantum dot according to claim 2, wherein the quantum dot emitting red light is CdSe.

4. The modified quantum dot according to claim 1, wherein the amine containing C6-C22 alkyl group is oil amine.

5. A colorant, comprising the modified quantum dots according to any one of claims 1 to 3.

6. The colorant according to claim 5, **characterized in** it is manufactured by mixing the modified quantum dots with a pigment dispersion, wherein the pigment dispersion comprises a pigment, a dispersant, a dispersion resin and a solvent.

7. The colorant according to claim 6, wherein the weight percents of the pigment, dispersant, dispersion resin and

solvent in the pigment dispersion are respectively 5-30%, 1-10%, 1-10% and 60-90%.

**8.** The colorant according to claim 5, wherein the quantum dot is a quantum dot emitting red light, the acid dye is a red acid dye.

**9.** The colorant according to claim 6, wherein the quantum dot emitting red light is CdSe.

**10.** A photosensitive resin composition, **characterized in** it comprises the colorant according to any one of claims 5 to 9.

**11.** The photosensitive resin composition according to claim 10, wherein the photosensitive resin composition further comprises an alkali-soluble resin, a monomer, an initiator, and a solvent, the total content of the colorant, alkali-soluble resin, monomer and initiator accounts for 10-40% by weight based on the photosensitive resin composition, the solvent accounts for 60-90% by weight based on the photosensitive resin composition.

**12.** The photosensitive resin composition according to claim 11, wherein the contents of the colorant, alkali-soluble resin, monomer, and initiator are respectively 10-80%, 5-60%, 5-60%, and 0.1-20% by weight based on the total amount thereof.

**13.** The photosensitive resin composition according to claim 12, wherein the contents of the colorant, alkali-soluble resin, monomer, and initiator are respectively 30-60%, 10-30%, 10-30%, and 1-10% by weight based on the total amount thereof.

**14.** A color filter, manufactured by the photosensitive resin composition according to any one of claims 10-13.

**15.** A display device, **characterized by** comprising the color filter according to claim 14.

**16.** A method for preparing a modified quantum dot, including:

making quantum dots be bonded with amine containing a C6-C22 alkyl group;
using an onium salt reagent to onium-salinize the quantum dots to form quantum dots containing ammonium salt groups;
salifying the quantum dots containing ammonium salt groups with an acid dye to obtain a modified quantum dot.

**17.** A method for preparing modified quantum dots according to claim 16, wherein the amine value of the quantum dot containing ammonium salt groups is 10 mgKOH/g to 200 mgKOH/g.

**18.** A method for preparing modified quantum dots according to claim 17, wherein the amine value of the quantum dot containing ammonium salt groups is 20 mgKOH/g to 130 mgKOH/g.

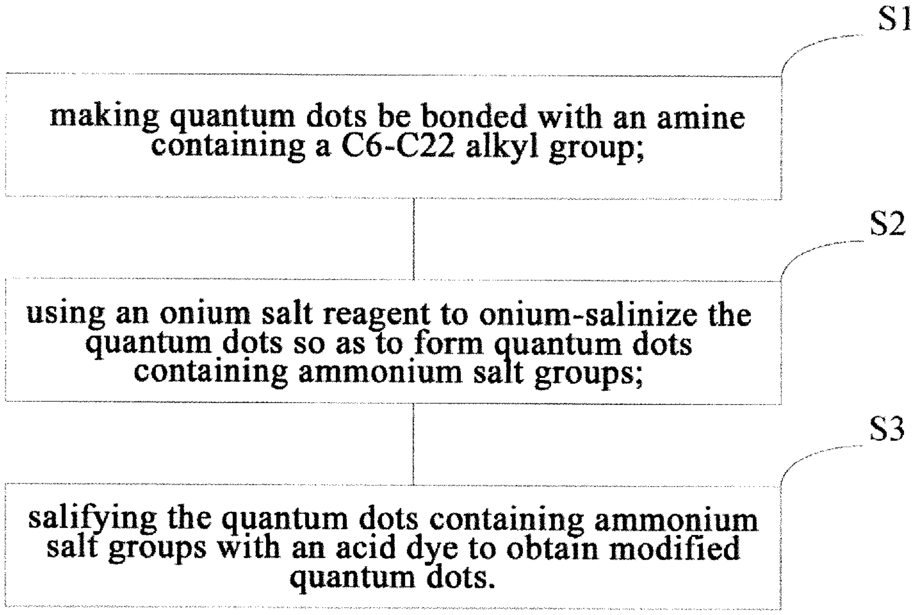
S1
making quantum dots be bonded with an amine containing a C6-C22 alkyl group;
S2
using an onium salt reagent to onium-salinize the quantum dots so as to form quantum dots containing ammonium salt groups;
S3
salifying the quantum dots containing ammonium salt groups with an acid dye to obtain modified quantum dots.

Fig. 1

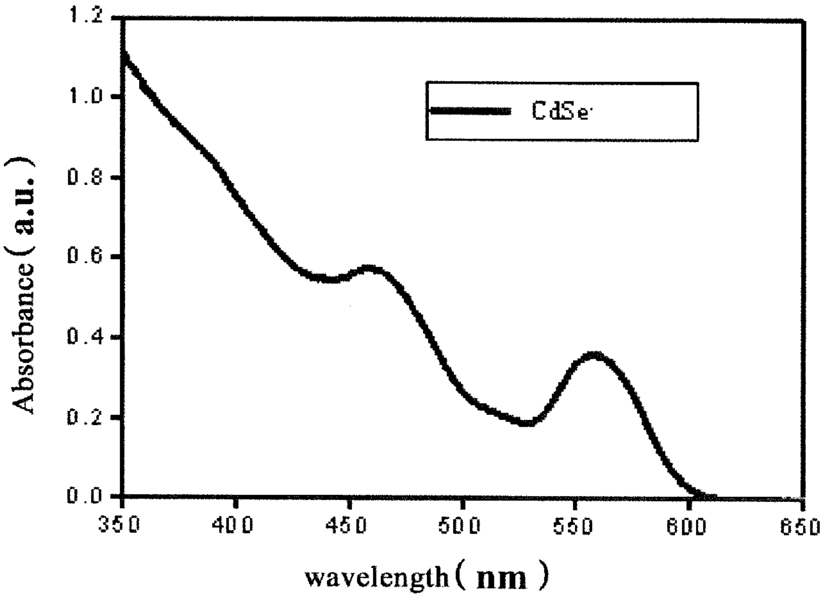
CdSe
Absorbance ( a.u. )
wavelength ( nm )
0.0
0.2
0.4
0.6
0.8
1.0
1.2
350
400
450
500
550
600
650

Fig. 2

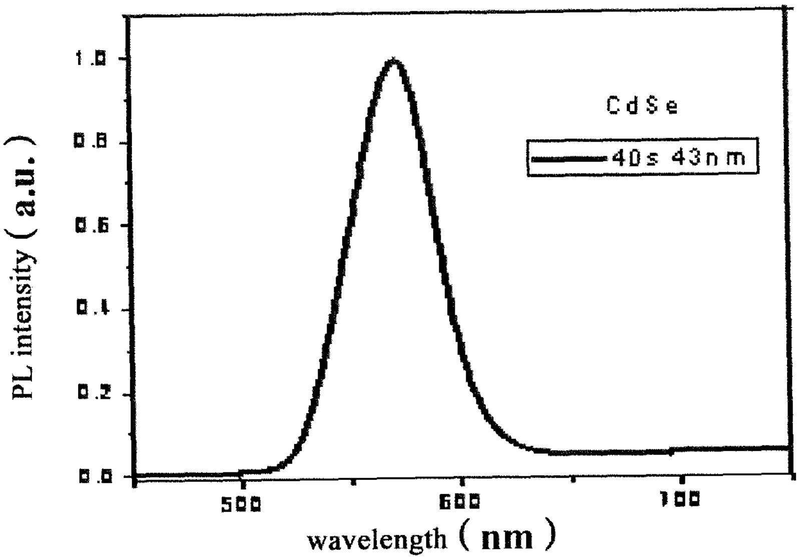

PL intensity ( a.u. )
1.0
0.8
0.6
0.4
0.2
0.0
CdSe
40s 43nm
500
600
700
wavelength ( nm )


Fig.3

| INTERNATIONAL SEARCH REPORT | International application No. PCT/CN2015/095105 |
|---|---|

**A. CLASSIFICATION OF SUBJECT MATTER**

C09K 11/88 (2006.01) i; C09K 11/02 (2006.01) i; G02B 5/20 (2006.01) i; G02B 1/04 (2006.01) i; G02F 1/1335 (2006.01) i; G03F 7/027 (2006.01) i

According to International Patent Classification (IPC) or to both national classification and IPC

B. FIELDS SEARCHED

Minimum documentation searched (classification system followed by classification symbols)

C09K11/-; G02B5/-; G02B1/-; G02F1/-; G03F7/-

Documentation searched other than minimum documentation to the extent that such documents are included in the fields searched

Electronic data base consulted during the international search (name of data base and, where practicable, search terms used)

CNPAT, CNKI, WPI, EPODOC: quantum dot?, nanocrystal, nanoparticle, +amine, ammonium?, dye, core, shell

C. DOCUMENTS CONSIDERED TO BE RELEVANT

| Category* | Citation of document, with indication, where appropriate, of the relevant passages | Relevant to claim No. |
|---|---|---|
| PX | CN 104479680 A (BOE TECHNOLOGY GROUP CO., LTD.) 01 April 2015 (01.04.2015) the whole document | 1-18 |
| A | CN 103361063 A (JIASHAN JUST-TEC MEDICAL INSTR CO., LTD.) 23 October 2013 (23.10.2013) claims 1-3, description paragraph [0023], embodiment 1 | 1-18 |
| A | CN 102936501 A (UNIV EAST CHINA SCI & TECHNOLOGY) 20 February 2013 (20.02.2013) the whole document | 1-18 |
| A | CN 203465442 U (BOE TECHNOLOGY GROUP CO., LTD.) 05 March 2014 (05.03.2014) the whole document | 1-18 |

☒ Further documents are listed in the continuation of Box C. ☒ See patent family annex.

* Special categories of cited documents:

"A" document defining the general state of the art which is not considered to be of particular relevance

"E" earlier application or patent but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&"document member of the same patent family

| Date of the actual completion of the international search | Date of mailing of the international search report |
|---|---|
| 27 January 2016 | 03 February 2016 |
| Name and mailing address of the ISA<br>State Intellectual Property Office of the P. R. China<br>No. 6, Xitucheng Road, Jimenqiao<br>Haidian District, Beijing 100088, China<br>Facsimile No. (86-10) 62019451 | Authorized officer<br>ZHANG, Dan<br>Telephone No. (86-10) 62086317 |

Form PCT/ISA /210 (second sheet) (July 2009)

## INTERNATIONAL SEARCH REPORT

International application No.
PCT/CN2015/095105

C (Continuation). DOCUMENTS CONSIDERED TO BE RELEVANT

| Category* | Citation of document, with indication, where appropriate, of the relevant passages | Relevant to claim No. |
|---|---|---|
| A | CN 103146262 A (BOE TECHNOLOGY GROUP CO., LTD.) 12 June 2013 (12.06.2013) the whole document | 1-18 |
| A | CN 102863964 A (SHANGHAI JIAOTONG UNIVERSITY) 09 January 2013 (09.01.2013) the whole document | 1-18 |
| A | WO 2007137292 A2 (HAYES JAMES et al.) 29 November 2007 (29.11.2007) the whole document | 1-18 |

Form PCT/ISA /210 (continuation of second sheet) (July 2009)

## INTERNATIONAL SEARCH REPORT
Information on patent family members

International application No.
PCT/CN2015/095105

| Patent Documents referred in the Report | Publication Date | Patent Family | Publication Date |
|---|---|---|---|
| CN 104479680 A | 01 April 2015 | None | |
| CN 103361063 A | 23 October 2013 | None | |
| CN 102936501 A | 20 February 2013 | CN 102936501 B | 12 February 2014 |
| CN 203465442 U | 05 March 2014 | None | |
| CN 103146262 A | 12 June 2013 | US 2014158954 A1 | 12 June 2014 |
| CN 102863964 A | 09 January 2013 | CN 102863964 B | 13 November 2013 |
| WO 2007137292 A2 | 29 November 2007 | US 2008277626 A1 | 13 November 2008 |
| | | WO 2007137292 A3 | 31 July 2008 |

Form PCT/ISA /210 (patent family annex) (July 2009)